# EUROPÄISCHE PATENTANMELDUNG

(11) **EP 1 976 362 A2**
(43) Veröffentlichungstag der Anmeldung: **01.10.2008**
(21) Anmeldenummer: 08102911.8
(22) Anmeldetag: 26.03.2008
(51) Int. Cl.: H05K 13/00, H05K 13/04

(54) **Vorrichtung und Verfahren zum Aufbringen eines viskosen Mediums auf Substrate**

(30) Priorität: 30.03.2007 DE 102007015536
(71) Anmelder: SIEMENS AKTIENGESELLSCHAFT, 80333 München (DE)
(72) Erfinder: Fricke, Christian, 85221, Dachau (DE); Gray, Robert, Buford, GA 30518 (US); Krause, Gerd, 74357, Bönnigheim (DE); Lion, Wolfgang, 90602, Pyrbaum (DE); Müller, Wolfgang, 89160, Dornstadt (DE); Schmidt, Holger, 82131, Gauting (DE)

(57) **Zusammenfassung**

Es wird eine Vorrichtung (100, 300) zum Aufbringen eines viskosen Mediums auf Substrate (102) vorgestellt, mit
einer Bearbeitungsstation (104), bei der auf die Oberfläche einzelner Substrate (102) das viskose Medium aufgebracht wird;
einer Übergabestation (120) zum Übergeben der einzelnen mit dem viskosen Medium versehenen Substrate (102) an einen Werkstückträger (123), wobei der Werkstückträger (123) zum Fixieren einer Vielzahl von Substraten (102) ausgebildet ist;
einer ersten Transportvorrichtung (123) zum Transportieren des Werkstückträgers (123) zusammen mit den fixierten Substraten (102) in einer ersten Transportrichtung (125) in Richtung eines Bestückbereichs.

## Beschreibung

Die Erfindung bezieht sich auf eine Vorrichtung und ein Verfahren zum Aufbringen eines viskosen Mediums auf Substrate.

Bestücklinien zum Herstellen von mit elektronischen Bauelementen bestückten Substraten, beispielsweise Leiterplatten, umfassen typischerweise eine Vielzahl von Bestückmaschinen, sowie vor den Bestückmaschinen eine Druckmaschine zum Aufbringen eines viskosen Mediums wie beispielsweise einer Lotpaste bzw. eines Leitklebers zur Befestigung und anschließenden Kontaktierung der Bauelemente auf den dafür vorgesehenen Plätzen auf der Oberfläche der Substrate. Bei der Verwendung von Lotpaste ist nach den Bestückmaschinen in der Regel ein Ofen, beispielsweise ein sog. "Reflow-Ofen" vorgesehen, in welchem die Lotpaste, welche sich zwischen Anschlüssen der Bauelemente und dazugehörigen Kontaktflächen der Leiterplatte befindet, schmilzt. Nach anschließendem Abkühlen sind die aufgesetzten Bauelemente fest und leitend mit den Kontaktflächen der Leiterplatte verbunden.

Bisher werden kleine Leiterplatten (z.B. Leiterplatten in Mobiltelefonen) in so genannten Mehrfachnutzen der Bestücklinie zugeführt. Ein solcher Mehrfachnutzen ist beispielsweise eine große Platte, bestehend aus mehreren kleinen Bereichen, die jeweils einer späteren kleinen Leiterplatte entsprechen. Der Prozess "Bedrucken der Leiterplatte mit Lotpaste" ist dabei häufig taktzeitbestimmend für den Liniendurchsatz. Eine Erhöhung des Liniendurchsatzes ist beispielsweise durch Parallelschalten mehrerer Drucker möglich. Dieses Verfahren benötigt allerdings eine große Stellfläche und zusätzliche Vorrichtungen zum Transport der Leiterplatten, wie zusätzliche Transportbänder oder Transportschlitten ("Shuttles"), da die Drucker durch diese Vorrichtungen mit der Bestücklinie verbunden werden. Am Ende der Bestücklinie werden die Mehrfachnutzen in einem eigenen Prozess zu Einzelschaltungen getrennt, um diese nachfolgenden Test- und Montageprozessen zuzuführen.

Durch den Herstellungsprozess der großen Platte des Mehrfachnutzens entstehen teilweise Fehler in Einzelschaltungen, also in einzelnen der jeweils kleinen Leiterplatten. Diese fehlerhaften Leiterplatten, bzw. Einzelschaltungen, werden mit durch die Linie transportiert. Spezielle Fehlermarken müssen gelesen werden, um diese fehlerhaften Leiterplatten zu erkennen. Der Transport der ausmarkierten Einzelschaltungen und das zusätzliche Lesen der Fehlermarken ("Bad Board"-Marken) vermindern die Linienleistung. Alternativ können die schlechten Einzelschaltungen auch mit bestückt und erst am Ende der Bestücklinie verworfen werden, was allerdings aufgrund der verwendeten und dann nicht mehr benötigten Bauelemente hohe Kosten verursacht. Eine weitere Alternative besteht im Vermessen des Nutzens beim Nutzenhersteller und der ausschließlichen Lieferung von vollständig positiv getesteten Nutzen. Diese Vorselektion führt allerdings ebenfalls zu erhöhten Kosten.

Des weiteren lassen sich Verzüge in einem Mehrfachnutzen gegenüber einer dementsprechend großen Schablone häufig nicht ausregeln, so dass sich in diesem Fall häufig nicht alle Einzelschaltungen zufrieden stellend bedrucken lassen.

Es ist daher die Aufgabe der Erfindung ein verbessertes Verfahren und eine verbesserte Vorrichtung zum Aufbringen eines viskosen Mediums auf Substrate anzugeben.

Die Aufgabe wird erfindungsgemäß gelöst durch eine Vorrichtung mit
- einer Bearbeitungsstation, bei der auf die Oberfläche einzelner Substrate das viskose Medium aufgebracht wird;
- einer Übergabestation zum Übergeben der einzelnen mit dem viskosen Medium versehenen Substrate an einen Werkstückträger, wobei der Werkstückträger zum Fixieren einer Vielzahl von Substraten ausgebildet ist;
- einer ersten Transportvorrichtung zum Transportieren des Werkstückträgers zusammen mit den fixierten Substraten in einer ersten Transportrichtung in Richtung eines Bestückbereichs.

Darüber hinaus wird ein Verfahren zum Herstellen von mit Bauelementen bestückten Substraten vorgestellt, bei dem
- auf einzelne Substrate das viskose Medium aufgebracht wird;
- eine Vielzahl der einzelnen mit dem viskosen Medium versehenen Substrate auf einem Werkstückträger fixiert werden und
- die Vielzahl der einzelnen Substrate zusammen mit dem Werkstückträger in einen Bestückbereich zum dortigen Bestücken mit Bauelementen transportiert wird.

Durch das Aufbringen des viskosen Mediums auf einzelne Substrate und anschließendes Zusammenfassen der einzelnen Substrate in einem Werkstückträger kann der Prozess des Aufbringens des viskosen Mediums in Bezug auf das einzelne Substrat sehr genau durchgeführt werden, während das anschließende Zusammenfassen der einzelnen Substrate in einem Werkstückträger zu hohen Geschwindigkeiten bei der Bestückung führt. Die Bestückung lässt sich durch Vermessungssysteme im Bestückautomaten genau im Bezug auf die einzelnen Substrate ansteuern.

Durch die Bearbeitung einzelner Substrate können bereits vereinzelte Substrate zur Weiterverarbeitung in der erfindungsgemäßen Vorrichtung verwendet werden. Daher kann vorher bereits eine Qualitätskontrolle der einzelnen Substrate erfolgen und beispielsweise können nur einwandfreie Substrate für den Prozess des Aufbringens des viskosen Mediums vorgesehen werden. Dadurch wird von vornherein Material vom viskosen Medium eingespart, da bereits als defekt markierte Substrate nicht mit dem viskosen Medium versehen werden.

In einem Ausführungsbeispiel wird eine Schablone zum Aufbringen des viskosen Mediums verwendet. Dabei werden in der Bearbeitungsstation die Schablone und die einzelnen Substrat mit der Hilfe von optischen Vermessungssystem zueinander justiert. Ein erstes optisches Vermessungssystem bestimmt die Position von Positioniermarken auf der Schablone und Positioniermarken auf der der Schablone abgewandten Oberfläche des Substrats. Im Regelfall wird diese gegenüber der Schablone abgewandte Oberfläche die Unterseite des Substrats sein, da das viskose Medium auf die Oberseite des Substrats aufgetragen wird. Bereits vor der Bearbeitungsstation werden Positioniermarkierungen auf beiden Oberflächen des Substrat beispielsweise mithilfe eines zweiten optischen Vermessungssystems vermessen. In einer mit dem ersten und dem zweiten optischen Vermessungssystem verbundenen Steuereinheit kann daraus der aktuelle Versatz zwischen der Schablone und dem Substrat vermessen werden und beispielsweise durch eine Ansteuerung eines Hubtischs bzw. eine Bewegung der Schablone ausgeglichen werden.

Das zweite optische Vermessungssystem kann auch als "fiducial measuring system" bezeichnet werden, in dem beispielsweise über ein Kamerasystem in beschriebener Art und Weise eine Korrelation zwischen den Positioniermarkierungen auf der Oberseite des Substrats und den Positioniermarkierungen auf der Unterseite des Substrats erzeugt wird. In der Bearbeitungsstation, was auch als "Druckposition" bezeichnet wird, unter der Schablone werden nur die Positioniermarken auf der Unterseite des Substrats noch einmal gelesen. Durch die Korrelation ist die Lage der Oberseite bekannt und das Ausrichten der Oberseite des Substrats zur Schablone möglich.

In vorteilhafter Weise ist die Schablone so ausgebildet, dass im wesentlichen gleich aufgebaute Teilbereiche der Schablone vorgesehen sind. Dabei wird jeweils ein Teilbereich aktiv für das Aufbringen des viskosen Mediums genutzt. Der andere Teilbereich kann beispielsweise während des Aufbringens des viskosen Mediums durch den ersten Teilbereich gereinigt werden. Durch ein Wechselsystem lässt sich bei verschmutztem aktiven Teilbereich dieser Teilbereich mit dem gereinigten Teilbereich austauschen, wodurch der gereinigte Teilbereich zum aktiven Teilbereich wird und der ehemals aktive Teilbereich gereinigt werden kann. Der Wechsel der Schablone von einem Teilbereich zum anderen geschieht während der Wechselzeit der Substrate, so dass durch die Parallelität der Prozesse die Zykluszeit minimiert werden kann.

In einem weiteren Ausführungsbeispiel ist vorgesehen, dass mindestens zwei im Wesentlichen gleich aufgebaute Schablonen benutzt werden, von denen nur eine momentan zum Aufbringen des viskosen Mediums genutzt wird. Durch das Wechselsystem lassen sich die zwei Schablonen austauschen und die jeweils nicht benutzte Schablone kann in einer Reinigungsvorrichtung gereinigt werden.

Durch eine einmalige Vermessung der Lage der Schablone nach einem Positionswechsel der Schablone durch Kameras von der Oberseite, ist kein verfahrbares Kamerasystem zwischen Substrat und Schablone vor jedem Druck erforderlich.

In einem weiteren Ausführungsbeispiel werden mehrere Substrate, beispielsweise zwei Substrate, gleichzeitig in die Bearbeitungsstation transportiert und dort gleichzeitig mit viskosem Material versehen, wodurch die Bearbeitungsgeschwindigkeit erhöht wird.

In einem weiteren Ausführungsbeispiel wird die Qualität des Aufbringens des viskosen Mediums, also beispielsweise die Qualität des Lotpastendrucks, in einem optischen Inspektionssystem kontrolliert. Substrate mit einer schlechten Qualität werden anschließend aussortiert und somit nicht in den Bestückbereich transportiert. Diese Selektion kann beispielsweise vor dem Transport in den Werkstückträger, oder auch erst nachdem die Substrate schon an den Werkstückträger übergeben wurden, erfolgen.

Damit ist sichergestellt, dass nur gute Substrate und gute Drucke in der Bestücklinie weiter verarbeitet werden.

In einem weiteren Ausführungsbeispiel werden im Werkstückträger sowohl bereits einseitig bestückte Substrate als auch noch unbestückte Substrate fixiert und zusammen in den Bestückbereich transportiert. Da sich in der Regel ein Bestückinhalt von der Oberseite und der Unterseite bei doppelseitig zu bestückenden Substraten stark unterscheiden kann, lässt sich dadurch eine verbesserte Linienleistung erreichen, da während des anschließenden Bestückvorgangs immer sowohl Unter- als auch Oberseiten der Substrate bestückt werden. Dadurch ist vor allem eine gleichmäßige Linienauslastung sichergestellt, denn es wird der Fall vermieden, dass nach einem beispielsweise sehr zeitintensivem Bestückprozess für eine der Seiten des Substrats anschließend ein sehr kurzer Bestückprozess für die nur mit wenigen Bauelementen zu bestückende Seite folgt.

In vorteilhafter Weise sind für die Herstellung von beidseitig bestückten Substraten eine Drehstation zum Drehen der Substrate bzw. eine Kippstation zum Kippen des Werkstückträger vorgesehen, um nach dem Drehen bzw. Kippen die jeweils andere Oberfläche der Substrate mit dem viskosen Medium zu versehen. Dafür werden die Substrate jeweils an den Anfang der Vorrichtung zurücktransportiert.

Anhand der Figuren der Zeichnung wird die Erfindung mittels Ausführungsbeispielen näher erläutert.

Dabei zeigen
- Fig.1: eine Draufsicht auf ein Ausführungsbeispiel einer Vorrichtung zum Aufbringen eines viskosen Mediums auf Substrate,
- Fig. 2a: eine schematische Seitenansicht für die Vermessung der Positioniermarken auf dem Substrat und
- Fig. 2b: eine schematische Seitenansicht für die Vermessung der Positioniermarken an der Schablone und auf der der Schablone abgewandten Oberfläche des Substrats,
- Fig. 3: eine Draufsicht auf ein weiteres Ausführungsbeispiel einer Vorrichtung zum Aufbringen eines viskosen Mediums auf Substrate.

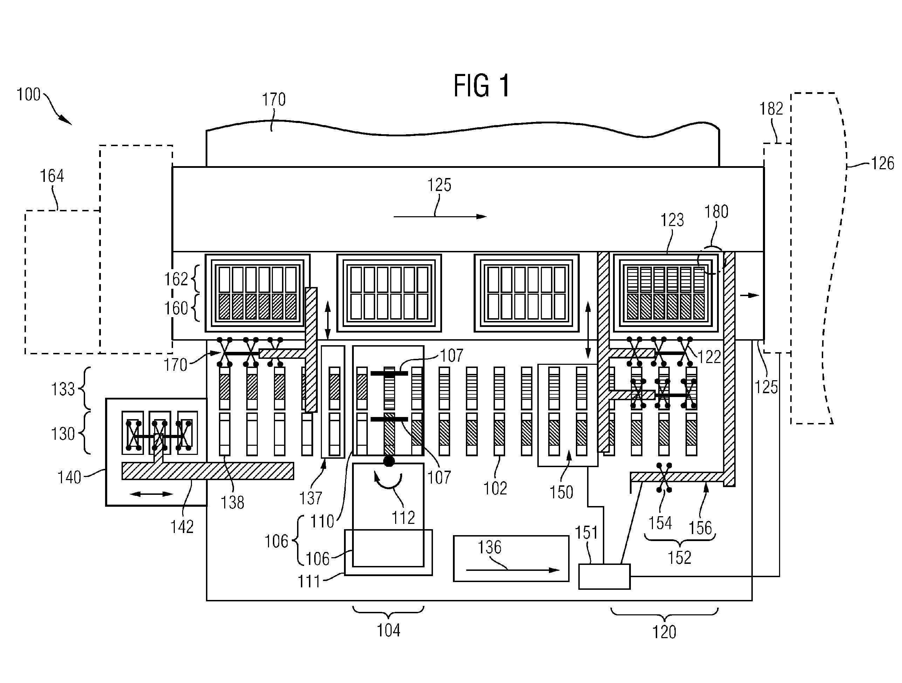

In Figur 1 ist in einer Draufsicht ein Ausführungsbeispiel eine erfindungsgemäße Vorrichtung 100 dargestellt. Dabei werden einzelne Substrate 102 in einer Bearbeitungsstation 104, beispielsweise einer Druckstation, durch Verwendung einer Schablone 106 ("Stencil") und in diesem Fall von zwei Rakeln 107 (in der Regel je ein Rakel 107 pro Substrat 102) mit einem viskosen Medium, beispielsweise einer Lotpaste oder eines Leitkleber, beaufschlagt, so dass die Kontaktflächen auf der Oberfläche des Substrats 102, beispielsweise einer kleinen Leiterplatte für ein Mobiltelefon, mit dem viskosen Medium bedeckt sind.

Die Schablone 106 weist dabei einen passiven Teilbereich 108 und einen aktiven Teilbereich 110 auf, die im Wesentlichen gleich aufgebaut sind, beispielsweise das gleiche Muster für das Aufbringen des viskosen Mediums auf die Substrate 102 aufweisen. Während der passive Teilbereich 108 in einer Reinigungsvorrichtung 111 gereinigt wird, wird der aktive Teilbereich 110 für das Aufbringen des viskosen Mediums benutzt.

Eine Wechselvorrichtung 112, in Figur 1 schematisch durch eine Drehbewegungspfeil angedeutet, bewirkt einen Wechsel der aktiven und passiven Teilbereiche 108, 110, sobald der aktive Teilbereich stark verschmutzt ist. Der Wechsel kann bei einem Weitertransport der Substrate 102 erfolgen, so dass keine zusätzliche Wechselzeit verloren geht.

Die bedruckten Substrate 102 werden in einer Übergabestation 120, beispielhaft dargestellt durch erste Greifereinheiten 122 an einen Werkstückträger übergeben, dort wird eine Mehrzahl an bedruckten Substraten 102 fixiert und gemeinsam mittels einer ersten Transportvorrichtung, beispielsweise einem ersten Transportband 124 in einer Transportrichtung 125 in den Bestückbereich eines Bestückautomaten 126 transportiert, der hier nur angedeutet dargestellt ist.

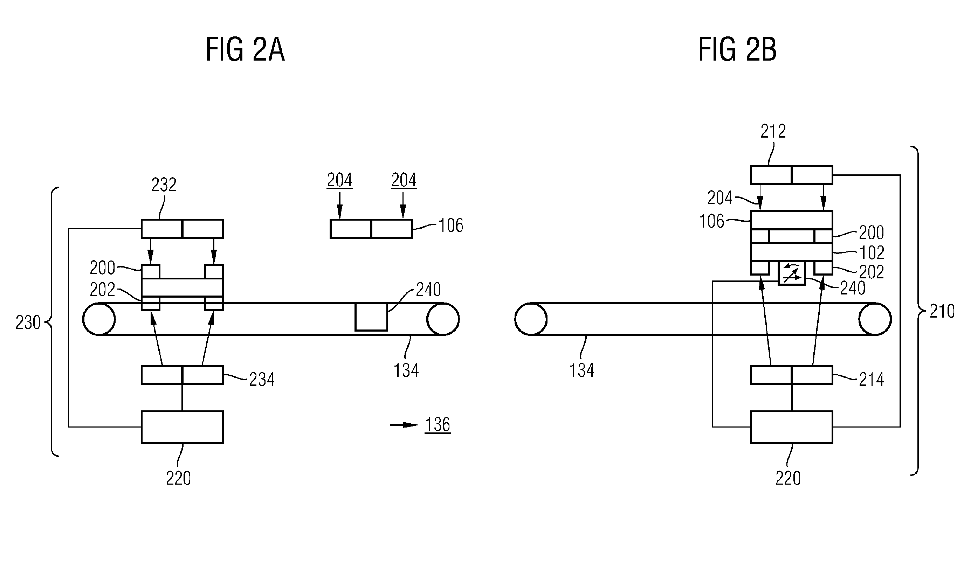

Dargestellt ist ein Ausführungsbeispiel, bei dem die Substrate in zwei parallelen Reihen 130, 132 durch die Vorrichtung 100 durch eine zweite Transportvorrichtung 134, beispielsweise ein zweites Transportband (in Fig. 2 dargestellt) in einer zweiten Transportrichtung 136 transportiert werden, wobei auch jeweils zwei der Substrate 102 gemeinsam in der Bearbeitungsstation 104 mit beispielsweise Lotpaste bedruckt werden. Die Substrate 102 können dabei beispielsweise in Substratträgern 138 auf dem Transportband 134 bewegt werden.

Die zwei parallelen Reihen 130, 132 werden beispielsweise genutzt, um in effizienter Weise beidseitige bestückte Substrate 102 herzustellen.

Im dargestellten Ausführungsbeispiel werden die einzelnen bereits separierten Substrate 102 von einem Lieferanten angeliefert, beispielsweise in einem Magazin 140, von einer zweiten Greifereinheit 142 aus dem Magazin 140 entnommen und mittels der zweiten Transportvorrichtung 134 in der in Figur 1 unteren Reihe 130 der Schablone 106 zugeführt. Die Justage des Substrats 102 zur Schablone 106 wird im Folgenden anhand der Figuren 2a und 2b erläutert.

Figur 2a zeigt schematisch in einer Seitenansicht die Vermessung der Positionsmarken 200 auf der der Schablone 106 zugewandten Oberfläche des Substrats 102 und die Vermessung der Positionsmarken 202 auf der der Schablone 106 abgewandten Oberfläche des Substrate 102. In Figur 2b ist die Vermessung von Positioniermarken 204 der Schablone 106 und von den Positioniermarken 202 auf der der Schablone 106 abgewandten Oberfläche des Substrats 102 dargestellt in der Bearbeitungsstation 104 dargestellt. Dafür dient in Fig.2b ein erstes optisches Vermessungssystem 210, welches beispielsweise eine erste Kamera 212 zum Vermessen der Positioniermarken 204 der Schablone 106 und eine zweite Kamera 214 zum Vermessen der Positioniermarken auf der der Schablone 106 abgewandten Oberfläche des Substrats 102 umfasst. Das erste optische Vermessungssystem 210 ist mit einer Steuereinheit 220 verbunden. Die Positioniermarken 204 der Schablone sind dabei beispielsweise durchgeätzt wie auch die Struktur der Schablone 106 zum Aufbringen des viskosen Mediums.

Damit die Justage der Schablone 106 zur der Schablone 106 zugewandten Oberfläche des Substrats 102 erfolgen kann und die Positioniermarkierungen 200 auf der der Schablone 106 zugewandten Oberfläche in der Bearbeitungsstation schwer zugänglich sind (die Schablone 106 verhindert im Regelfall die optische Erkennung dieser Positioniermarkierungen 200), wird - wie in Figur 2a dargestellt - vor dem Erreichen der Bearbeitungsstation 104 in einer Position 137 durch ein zweites optisches Vermessungssystem 230 die Lage der Positioniermarkierungen 200, 202 auf beiden Oberflächen des Substrats 102 bestimmt. Das zweite optische Vermessungssystem 230 umfasst dafür beispielsweise eine dritte Kamera 232 zum Vermessen der Positioniermarkierungen auf der Schablone 106 zugewandten Oberfläche des Substrats 102 und eine vierte Kamera 234 zum gleichzeitigen Vermessen der Positioniermarkierungen 202 auf der der Schablone abgewandten Oberfläche des Substrats 102. Statt der beschriebenen ersten bis vierten Kamera 212, 214, 232, 234 können auch jeweils separate Kameras für jede Postioniermarkierung 200, 202 des Substrats 102 bzw. der Schablone 106 vorgesehen sein, die dann jeweils mit der Steuereinheit 220 verbunden sind.

Das zweite optische Vermessungssystem 230 ist ebenfalls mit der Steuereinheit 230 verbunden. Durch die Kenntnis der relativen Lage der Positioniermarkierungen 200, 202 auf beiden Oberflächen des Substrats und die Kenntnis der Lage der Schablone 106 zur Lage der Positioniermarkierungen 202 auf der der Schablone abgewandten Seite kann die Steuereinheit 230 einen Hubtisch 240 so ansteuern, dass eine optimale Lage des Substrats 102 zur Schablone 106 erzielt wird. Dafür ist der Hubtisch 240 lateral und rotatorisch in einer Ebene parallel zur Oberfläche des Substrats 102 beweglich, wie es in Figur 2b durch die Pfeile angedeutet ist.

Einzelne Komponenten des ersten optischen Vermessungssystems 210 und des zweiten optischen Vermessungssystems 230 können dabei auch gemeinsam genutzt werden, beispielsweise könnte statt der ersten Kamera 212 und der dritten Kamera 232 nur eine gemeinsame verfahrbare Kamera vorgesehen sein, wie auch statt der zweiten Kamera 214 und der vierten Kamera 234 nur eine verfahrbare Kamera vorgesehen sein kann.

Die einseitig bedruckten Substrate 102 werden anschließend von einem optischen Inspektionssystem 150 inspiziert. Dabei können fehlerhaft bedruckte Substrate 102 identifiziert werden. Durch einen über eine Steuereinrichtung 151 mit dem optischen Inspektionssystem 150 verbundenen Selektionsmechanismus 152, hier dargestellt durch einen an einem Portalsystem 156 befestigten Greifer 154, lassen sich fehlerhafte Substrate aus dem System ausschleusen. Anschließend kann beispielsweise ein ordnungsgemäß bedrucktes Substrat 102 durch die zweite Transportvorrichtung 134 der Übergabestation 120 zugeführt werden und statt des aussortierten Substrats 102 dem Werkstückträger 123 übergeben werden. Dadurch ist gewährleistet, dass nur einwandfrei bedruckte Substrate 102 im Bestückbereich des Bestückautomaten 126 bestückt werden.

Im dargestellten Beispiel werden die einseitig bedruckten Substrate innerhalb des Werkstückträgers in einer ersten Reihe 160 angeordnet. Nach Durchlaufen des Bestückbereichs und verlöten der Kontakte, wird der Werkstückträger durch eine schematisch gezeigte Rücktransportvorrichtung 164 zurück transportiert (in Figur 1 die Position am weitesten links). Die einseitige bedruckten, bestückten und gelöteten Substrate 102 werden durch vierte Greifereinheiten 170 dem Werkstückträger 123 entnommen und werden dabei in einer beispielsweise in den vierten Greifereinheiten 170 integrierten Drehstation gedreht, so dass die bestückte Oberfläche nun die der Schablone 106 abgewandte Oberfläche ist. Die gedrehten Substrate 102 werden beispielsweise in der zweiten Reihe 132 angeordnet und mittels der Transportvorrichtung 134 gleich getaktet mit der ersten Reihe 130 der Schablone 106 zugeführt. Die Schablone 106 hat ein für die zweite Seite der Substrate 102 angepasstes Muster und daher können gleichzeitig unterschiedliche Oberflächen unterschiedlicher Substrate mit dem viskosen Medium versehen werden. Nach dem Bedrucken der zweiten Seite in der Schablone 106 werden diese Substrate 102 durch das optische Inspektionssystem 150 überprüft, gegebenenfalls durch den Selektionsmechanismus 152 aussortiert und ansonsten in die zweite Reihe 162 des Werkstückträgers einsortiert und dort fixiert. Nach dem Bestücken der zweiten Seite und einem nachfolgenden Lötschritt werden die zweiseitig bestückten Substrate dem Werkstückträger 123 entnommen und nachfolgenden Bearbeitungsschritten zugeführt, beispielsweise einer Montage.

Zur Vorrichtung 100 kann eine weitere gleich aufgebaute Vorrichtung 170 (nur schematisch angedeutet) vorgesehen sein, um beispielsweise Bestückmaschinen mit einem parallelen Doppeltransport mit gedruckten Substraten zu versorgen.

Die Werkstückträger 123 sind so konstruiert, dass nach dem Beladen der einzelnen Substrate 102, diese Substrate 102 im Werkstückträger 123 geklemmt werden und sich daher die relative Lage im Werkstückträger 123 durch den Transport durch die Bestückmaschine 126 (ggf. auch mehrere Bestückmaschinen) nicht mehr ändert. An jedem Werkstückträger 123 sind globale Passmarken 180 angebracht. Diese globalen Passmarken können durch ein drittes optisches Vermessungssystem 182 oder durch ein Vermessungssystem in einer ersten Bestückmaschine 126 vermessen werden und mit den Positioniermarkierungen 200 der Substrate 102 in Beziehung gesetzt werden. Diese Beziehung zwischen Positioniermarkierungen 200 und globalen Passmarken 180 kann an die Steuereinheiten nachfolgender Bestückmaschinen übermittelt werden, wodurch in den nachfolgenden Bestückmaschinen eine erneute Vermessung aller Positioniermarkierungen 200entfallen kann.

Die Anzahl der Substrate 102 im Werkstückträger 123 kann so gewählt werden, dass sich zwischen dem Nutzen der Vorrichtung 100 und der Bestückleistung des Bestückautomaten 126 ein Optimum ergibt. Der Bestückinhalt von Oberseite und Unterseite doppelseitig bestückter Substrate 102 unterscheidet sich oft sehr stark.

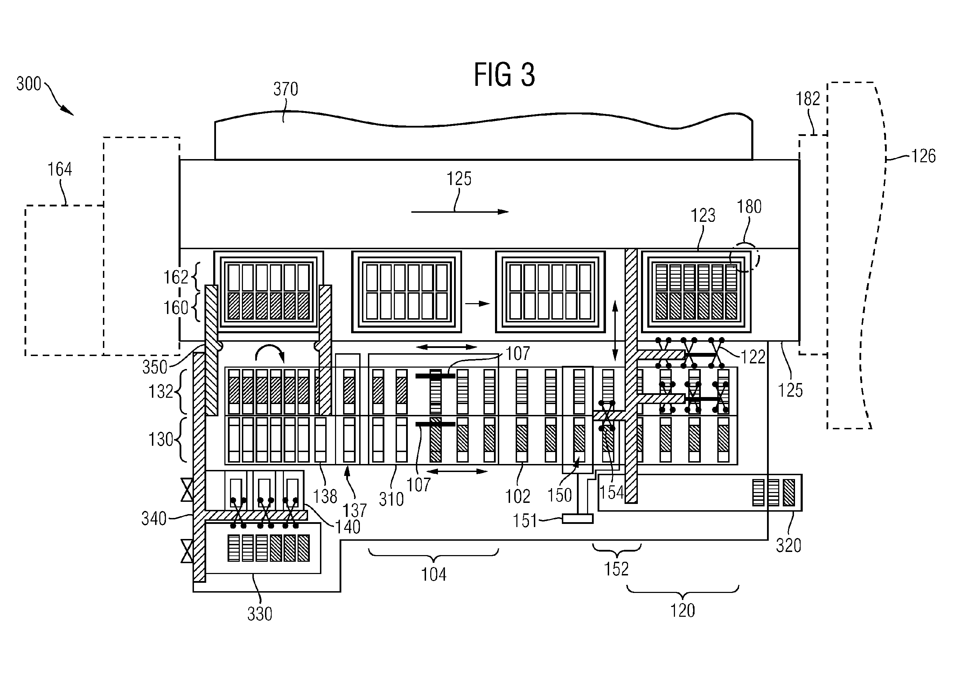

In Figur 3 ist ein weiteres Ausführungsbeispiel einer Vorrichtung 300 für das Aufbringen eines viskosen Mediums auf Substrate 102 dargestellt. Dabei entsprechen Teile mit gleichen Bezugszeichen den in Fig. 1 beschriebenen Teilen.

Dabei ist statt der Schablone 106 mit den zwei Teilbereichen 108, 110 nun vorgesehen, dass mindestens zwei im Wesentlichen gleich aufgebaute Schablonen 310 zum Bedrucken verwendet werden, von denen während des Druckprozesses allerdings nur eine Schablone 310 mit den Substraten 102 im Kontakt ist. Die beiden Schablonen können durch ein Wechselsystem (nicht dargestellt) gewechselt werden. In einer (in Fig. 3 nicht dargestellt) Reinigungsvorrichtung kann die jeweils nicht benutzte Schablone 310 gereinigt werden.

Der Greifer 154 des Selektionsmechanismus 152 ist in Transportrichtung 125 vor der Übergabestation 120 angeordnet. Dadurch kann der Greifer 154 unabhängig von den ersten Greifereinheiten 122 für die Übergabe an den Werkstückträger 123 arbeiten. Der Greifer 154 legt die Substrate 102, die vom optischen Inspektionssystem 150 als fehlerhaft bedruckt identifiziert wurden, auf eine Ablage 320. Von dieser Ablage 320 können die fehlerhaft bedruckten Substrate 102 entnommen, gereinigt und danach wieder über eine Zuführeinheit 330 entnommen und wieder in die Vorrichtung 300 zum Bedrucken eingeführt werden.

Das Magazin 140 ist in diesem Ausführungsbeispiel parallel neben der zweiten Transportvorrichtung 134 und parallel neben der Zuführeinheit 330 angeordnet. So lässt sich eine vierte Greifereinheit 340 nutzen, um sowohl Substrate 102 aus dem Magazin 140 als auch aus der Zuführeinheit 330 zu entnehmen.

Des weiteren ist nach der Rückführung der Werkstückträger 123 mit einseitig bestückten Substraten 102 eine Kippstation 350 vorgesehen, die den zurückgeführten Werkstückträger 123 zusammen mit den darin befindlichen, einseitig bestückten Substraten kippt, wodurch die Substrate 102 nach dem Lösen der Fixierung im Werkstückträger 123 mit der unbestückten Seite nach oben in den Substratträgern 138 liegen. Danach können die entsprechend noch unbestückten Oberflächen bedruckt und anschließend bestückt werden.

Zur Vorrichtung 300 kann eine weitere gleich aufgebaute Vorrichtung 370 (nur schematisch angedeutet) vorgesehen sein, um beispielsweise Bestückmaschinen mit einem parallelen Doppeltransport mit gedruckten Substraten zu versorgen.

Der Rücktransport leerer Substratträger 138 lässt sich beispielsweise durch ein Liftsystem und eine unterhalb der beschriebenen Arbeitsebene verlaufendes Transportband realisieren.

Durch die erfindungsgemäße Vorrichtung und das erfindungsgemäße Verfahren werden u.a. folgende Vorteile erzielt:
- Erreichen eines hohen Liniendurchsatzes und kurzer Taktzeiten für das einzelne Substrat bei geringem Platzbedarf
- Es werden nur geprüfte und gute Substrate vom Hersteller geliefert und in der Bestücklinie verarbeitet, dadurch werden keine "Leerstellen" (Fehlerstellen im Nutzen) durch die Linie transportiert.
- Es werden Materialkosten eingespart. Einzelne Substrate, bzw. Einzelschaltungen sind auf Grund der Materialeinsparung bei der Herstellung günstiger als Mehrfachnutzen.
- Es wird Fertigungsausrüstung eingespart, beispielsweise sind nicht mehrere Drucker nötig und ein Nutzentrenner entfällt.

## Patentansprüche

1. Vorrichtung (100, 300) zum Aufbringen eines viskosen Mediums auf Substrate (102), mit
einer Bearbeitungsstation (104), bei der auf die Oberfläche einzelner Substrate (102) das viskose Medium aufgebracht wird;
einer Übergabestation (120) zum Übergeben der einzelnen mit dem viskosen Medium versehenen Substrate (102) an einen Werkstückträger (123), wobei der Werkstückträger (123) zum Fixieren einer Vielzahl von Substraten (102) ausgebildet ist;
einer ersten Transportvorrichtung (124) zum Transportieren des Werkstückträgers (123) zusammen mit den fixierten Substraten (102) in einer ersten Transportrichtung (125) in Richtung eines Bestückbereichs.

2. Vorrichtung (100, 300) nach Anspruch 1,
**dadurch gekennzeichnet, dass**
die Bearbeitungsstation (104) eine Schablone (106) zum definierten Aufbringen des viskosen Mediums zumindest auf Teilbereiche einer der Schablone (106) zugewandten Oberfläche der einzelnen Substrate (102) umfasst.

3. Vorrichtung (100, 300) nach Anspruch 2,
**dadurch gekennzeichnet, dass**
die Schablone (106) Positioniermarkierungen (204) aufweist; und dass
die Bearbeitungsstation (104) ein erstes optisches Vermessungssystem (210) aufweist, welches zum Vermessen der Positioniermarkierungen (204) der Schablone (106) ausgebildet ist.

4. Vorrichtung (100, 300) nach Anspruch 3,
**dadurch gekennzeichnet, dass**
das erste optische Vermessungssystem (210) zusätzlich zum Vermessen von Positioniermarkierungen (202) auf der der Schablone (106) abgewandten Oberfläche der einzelnen Substrate (102) ausgebildet ist, wenn sich die einzelnen Substrate (102) in der Bearbeitungsstation (104) befinden.

5. Vorrichtung (100, 300) nach Anspruch 4,
**gekennzeichnet durch**
eine zweite Transportvorrichtung (134) zum Transport der einzelnen Substrate (102) in einer zweiten Transportrichtung (136) zur Bearbeitungsstation (104) und
ein zweites optisches Vermessungssystem (230), welches der Bearbeitungsstation (104) in der zweiten Transportrichtung (136) vorgelagert ist und zum Vermessen von Positioniermarkierungen (200, 202) auf beiden Oberflächen der einzelnen Substrate (102) ausgebildet ist.

6. Vorrichtung (100, 300) nach Anspruch 5,
**dadurch gekennzeichnet, dass**
ein Hubtisch (240) vorgesehen ist, der so ausgestaltet ist, dass ein auf dem Hubtisch befindliches Substrat (102) gegen die Schablone (106) gedrückt werden kann, sowie dass eine laterale und eine rotatorische Bewegung des Hubtischs (240) in einer Ebene parallel zur Oberfläche des Substrats (102) möglich sind,
eine Steuereinheit (220) vorgesehen ist, die mit dem ersten und mit dem zweiten optischen Vermessungssystem (210, 230) sowie mit dem Hubtisch (240) verbunden ist und so ausgebildet ist, dass die Steuereinheit (220) mithilfe der Daten des ersten und des zweiten optischen Vermessungssystems (210, 230) den Hubtisch (240) so steuert, dass eine der Schablone (106) zugewandte Oberfläche des Substrats (102) lagerichtig zur Schablone (106) justiert wird.

7. Vorrichtung (100, 300) nach einem der Ansprüche 2 bis 6,
**dadurch gekennzeichnet, dass**
die Schablone (106) einen ersten Teilbereich (108) und einen dazu im Wesentlichen gleich ausgebildeten zweiten Teilbereich (110) aufweist, von denen während des Aufbringens des viskosen Mediums nur einer des ersten und zweiten Teilbereichs (108, 110) benutzt wird, und
dass durch ein Wechselsystem (112) ein Wechsel zur Benutzung des jeweils anderen Teilbereichs (108, 110) ermöglicht wird.

8. Vorrichtung nach einem der Ansprüche 2 bis 6,
**dadurch gekennzeichnet, dass**
mindestens zwei Schablonen (106) vorgesehen sind, von denen während des Aufbringens des Mediums nur eine Schablone (106) benutzt wird, und
dass ein Wechselsystem (112) zum Wechsel der mindestens zwei Schablonen (106) vorgesehen ist, damit nach dem Wechsel die jeweils andere Schablone (106) zum Aufbringen des viskosen Mediums genutzt wird.

9. Vorrichtung (100, 300) nach einem der Ansprüche 7 oder 8,
**dadurch gekennzeichnet, dass**
eine Reinigungsvorrichtung (111) zur Reinigung des jeweils nicht benutzten Teilbereichs (108, 110) bzw. der nicht benutzten Schablone (106) vorgesehen ist.

10. Vorrichtung (100, 300) nach einem der Ansprüche 2 bis 9,
**dadurch gekennzeichnet, dass**
die Schablone (106) zum gleichzeitigen Aufbringen des viskosen Mediums auf mindestens zwei Substrate (102) ausgebildet ist.

11. Vorrichtung (100, 300) nach einem der Ansprüche 1 bis 10,
**gekennzeichnet durch**
ein optisches Inspektionssystem (150) zur Inspektion der Oberfläche der einzelnen Substrate (102).

12. Vorrichtung (100, 300) nach Anspruch 11,
**gekennzeichnet durch**
einen Selektionsmechanismus (152) zum Aussortieren von Substraten (102).

13. Vorrichtung (100, 300) nach Anspruch 12,
**dadurch gekennzeichnet, dass**
das optische Inspektionssystem (150) und der Selektionsmechanismus (152) mit einer Steuereinrichtung (151) verbunden sind, welche so ausgebildet ist, dass diese den Selektionsmechanismus (152) in Abhängigkeit einer Auswertung durch das optische Inspektionssystem (150) so steuert, dass Substrate (102), die den Anforderungen des nachfolgenden Bestückprozesses nicht genügen, nicht an den Werkstückträger (123) übergeben, sondern aus der Vorrichtung (100, 300) ausgeschleust werden.

14. Vorrichtung (100, 300) nach einem der Ansprüche 1 bis 13,
**dadurch gekennzeichnet, dass**
der Werkstückträger (123) mindestens zwei zur Transportrichtung (125) parallele Reihen (160, 162) von Plätzen für die einzelnen Substrate (102) aufweist.

15. Vorrichtung (100, 300) nach einem der Ansprüche 1 bis 14.
**dadurch gekennzeichnet, dass**
eine Drehstation (170) zum Drehen der einzelnen Substrate (102) nach Aufbringen des viskosen Mediums und anschließender Bestückung einer Oberfläche der einzelnen Substrate (102) vorgesehen ist.

16. Vorrichtung (100, 300) nach einem der Ansprüche 1 bis 14,
**dadurch gekennzeichnet, dass**
eine Kippstation (350) zum Kippen des Werkstückträgers (123) nach Aufbringen des viskosen Mediums und anschließender Bestückung einer Oberfläche der einzelnen Substrate (102) vorgesehen ist.

17. Vorrichtung (100, 300) nach einem der Ansprüche 1 bis 16,
**dadurch gekennzeichnet, dass**
ein drittes optisches Vermessungssystem (182) zum Bestimmen von Passmarken (180) am Werkstückträger (123) und von Positioniermarken (200, 202) der einzelnen Substrate (102) im Werkstückträger (123) vorgesehen ist.

18. Vorrichtung (100, 300) nach Anspruch 17,
**dadurch gekennzeichnet, dass**
dass das dritte optische Vermessungssystem (182) mit einer Steuereinrichtung (151) verbunden ist, wobei die Steuereinrichtung (151) so ausgebildet ist, dass die Ergebnisse des dritten optischen Vermessungssystems (182) an mindestens zwei nachfolgende Bestückvorrichtungen übermittelt werden kann.

19. Vorrichtung (100, 300) nach einem der Ansprüche 1 bis 18,
**dadurch gekennzeichnet, dass**
als viskoses Medium Lotpaste oder Leitkleber verwendet wird.

20. Verfahren zum Aufbringen eines viskosen Mediums auf Substrate (102), bei dem
auf einzelne Substrate (102) das viskose Medium aufgebracht wird;
eine Vielzahl der einzelnen mit dem viskosen Medium versehenen Substrate (102) auf einem Werkstückträger (123) fixiert werden und
die Vielzahl der einzelnen Substrate (102) zusammen mit dem Werkstückträger (123) in einen Bestückbereich zum dortigen Bestücken mit Bauelementen transportiert wird.

21. Verfahren nach Anspruch 20,
**dadurch gekennzeichnet, dass**
das viskose Medium mittels einer Schablone (106) auf die Substrate (102) aufgebracht wird.

22. Verfahren nach Anspruch 21,
**dadurch gekennzeichnet, dass**
die relative Position der Schablone (106) zu der der Schablone (106) zugewandten Oberfläche des einzelnen Substrats (102) vor dem Aufbringen des viskosen Mediums justiert wird, indem
- vor einem Transport der einzelnen Substrate (102) zur Schablone (106) die relative Position von Positioniermarken (200, 202) auf den beiden Oberflächen der einzelnen Substrate (102) vermessen wird,
- die Position der Schablone (106) vermessen wird und
- nach einem Transport der einzelnen Substrate (102) zur Position der Schablone (106) die Position von auf der der Schablone abgewandten Oberfläche des einzelnen Substrates (102) angebrachten Positioniermarken (202) vermessen wird und gegebenenfalls die Position des Substrats (102) zur Schablone (106) aufgrund der Positionsmessungen korrigiert wird.

23. Verfahren nach einem der Ansprüche 20 bis 22,
**dadurch gekennzeichnet, dass**
das viskose Medium wird auf mindestens zwei einzelne Substrate (102) gleichzeitig aufgebracht wird.

24. Verfahren nach einem der Ansprüche 20 bis 23,
**dadurch gekennzeichnet, dass**
die Schablone (106) aus einem ersten Teilbereich (108) und einem dazu im Wesentlichen gleich aufgebauten zweiten Teilbereich (110) besteht und jeweils nur einer der beiden Teilbereiche (108, 110) für das Aufbringen des viskosen Mediums benutzt wird.

25. Verfahren nach Anspruch 24,
**dadurch gekennzeichnet, dass**
der Teilbereich (110) gereinigt wird, der nicht zum Aufbringen des viskosen Mediums benutzt wird.

26. Verfahren nach einem der Ansprüche 20 bis 23,
**dadurch gekennzeichnet, dass**
mindestens zwei im Wesentlichen gleich aufgebaute Schablonen (106) benutzt werden, von denen jeweils nur eine für das Aufbringen des viskosen Mediums benutzt wird, während die andere Schablone (106) gereinigt wird.

27. Verfahren nach einem der Ansprüche 20 bis 26,
**dadurch gekennzeichnet, dass**
auf dem Werkstückträger (123) teilweise bereits einseitig bestückte Substraten (102) und teilweise noch unbestückte Substrate (102) fixiert werden.

28. Verfahren nach einem der Ansprüche 20 bis 27,
**dadurch gekennzeichnet, dass**
die mit dem viskosen Medium versehenen Oberflächen der Substrate (102) inspiziert werden und bei zu starker Abweichung von vorgegebenen Genauigkeitsanforderungen die entsprechenden Substrate (102) aussortiert werden.

29. Verfahren nach Anspruch 28,
**dadurch gekennzeichnet, dass**
nach dem Aussortieren eines Substrats (102) stattdessen ein weiteres Substrat (102) inspiziert und gegebenenfalls aussortiert oder an den Werkstückträger (123) übergeben wird.

30. Verfahren nach einem der Ansprüche 20 bis 29,
**dadurch gekennzeichnet, dass**
dass einseitige bestückte Substrate (102) zurück zur Schablone (106) transportiert und so gedreht werden, dass die vorher unbestückte Oberfläche mit dem viskosen Medium beaufschlagt wird.

31. Verfahren nach einem der Ansprüche 20 bis 30,
**dadurch gekennzeichnet, dass**
Relationen zwischen Passmarken (180) am Werkstückträger (123) und Positioniermarken (200, 202) auf den Oberflächen der Substrate (102) im Werkstückträger (123) vor dem Bestücken vermessen werden und die Relationen an nachfolgende Bestückprozesse weitergegeben werden.

32. Verfahren nach einem der Ansprüche 20 bis 31,
**dadurch gekennzeichnet, dass**
im Werkstückträger (123) sowohl einseitig als auch noch nicht bestückte Substrate (102) zusammen in den Bestückbereich transportiert und dort bei den bereits einseitig bestückten Substraten (102) die andere Oberfläche bestückt wird und bei den noch nicht bestückten Substraten (102) eine der Oberflächen.

33. Verfahren nach einem der Ansprüche 20 bis 32,
**dadurch gekennzeichnet, dass**
als viskoses Medium ein Leitkleber oder eine Lotpaste verwendet wird.
